# EUROPÄISCHE PATENTSCHRIFT

(11) **EP 2 310 919 B1**
(45) Veröffentlichungstag und Bekanntmachung des Hinweises auf die Patenterteilung: **24.12.2014**
(21) Anmeldenummer: 09780640.0
(22) Anmeldetag: 15.07.2009
(51) Int. Cl.: G05B 17/02

(54) **SCHALTUNG ZUR NACHBILDUNG EINER ELEKTRISCHEN LAST**
CIRCUIT FOR SIMULATING AN ELECTRICAL LOAD
CIRCUIT DE SIMULATION D'UNE CHARGE ÉLECTRIQUE

(30) Priorität: 21.07.2008 DE 102008034109
(43) Veröffentlichungstag der Anmeldung: 20.04.2011
(73) Patentinhaber: dSPACE digital signal processing and control engineering GmbH, 33102 Paderborn (DE)
(72) Erfinder: SCHULTE, Thomas, 33098 Paderborn (DE); BRACKER, Jörg, 33129 Delbrück (DE)
(86) Internationale Anmeldenummer: PCT/EP2009/059073
(87) Internationale Veröffentlichungsnummer: WO 2010/010022

(56) Entgegenhaltungen:
- EP-A1- 0 393 847
- WO-A1-2007/042228

## Beschreibung

Die Erfindung betrifft eine Schaltung zur Nachbildung einer elektrischen Last an einem Anschluss einer Testschaltung, wobei die Testschaltung wenigstens einen ersten Schalter und einen zweiten Schalter aufweist, wobei die Schaltung einen dritten Schalter und einen vierten Schalter aufweist, der erste Schalter und der zweite Schalter der Testschaltung über einen gemeinsamen ersten inneren Verbindungspunkt mit dem Anschluss der Testschaltung verbunden sind, der dritte Schalter und der vierte Schalter über einen gemeinsamen zweiten inneren Verbindungspunkt miteinander verbunden sind, der erste Schalter und der dritte Schalter über einen ersten äußeren Verbindungspunkt miteinander verbunden sind und der zweite Schalter mit dem vierten Schalter über einen zweiten äußeren Verbindungspunkt miteinander verbunden, so dass der erste Schalter, der zweite Schalter, der dritte Schalter und der vierte Schalter eine H-Brückenschaltung bilden, der erste äußere Verbindungspunkt und der zweite äußere Verbindungspunkt von einer Spannungsquelle mit einer Versorgungsspannung U_{B} beaufschlagt sind und der über den Anschluss der Testschaltung fließende Iststrom iᵢₛₜ über den zwischen dem Anschluss und dem zweiten Verbindungspunkt ausgebildeten Brückenquerzweig fließt, wobei und eine in dem Brückenquerzweig wirksame Induktivität vorgesehen ist.

Derartige Schaltungen zur Nachbildung einer elektrischen Last sind seit längerem bekannt, sie werden häufig dort verwendet, wo eine zu testende Schaltung - Testschaltung genannt - auf ihre Funktionalität hin zu überprüfen ist, ohne dass die Testschaltung in ihre "echte" Arbeitsumgebung gebracht werden muss.

Typische Anwendungsfelder sind z. B. Simulatoren - Testumgebungen - zur Überprüfung von Steuergeräten mit leistungselektronischen Schnittstellen. Hier bilden die Steuergeräte - beispielsweise Motorsteuergeräte - die Testschaltung, wobei es zu überprüfen gilt, ob die Steuergeräte in gewünschter Weise reagieren, ob also das Steuergerät auf bestimmte - über seine Schnittstellen empfangene - Zustandsgrößen mit einer geeigneten Ausgabe von - über seine Schnittstellen ausgegebene - Ausgangsgrößen reagiert. Dazu wird die relevante Umgebung einer solchen Testschaltung ganz oder teilweise simuliert. Im Falle eines Motorsteuergeräts kann beispielsweise mit Hilfe eines Simulationsrechners oder mehrerer Simulationsrechner mit I/O-Schnittstellen der anzusteuernde Motor - ganz oder teilweise - simuliert werden. Zu diesem Zweck wird zunächst ein mathematisches Abbild des Motors geschaffen, das die Kenndaten und Zustandsgrößen des Motors miteinander in einen berechenbaren Zusammenhang stellt. Die von dem Steuergerät auf den - simulierten - Motor einwirkenden Größen - Stellsignale -, werden von dem Simulationsrechner über eine I/O-Schnittstelle empfangen und auf dem Simulationsrechner werden unter anderem auf Grundlage dieser Informationen durch das mathematische Modell Zustandsgrößen des - nachgebildeten - Motors berechnet. Bestimmte Zustandsgrößen werden üblicherweise über die I/O-Schnittstelle bzw. die I/O-Schnittstellen dem Motorsteuergerät wieder zur Verfügung gestellt, soweit diese von dem Motorsteuergerät als Eingänge verlangt werden. Diese Vorgehensweise bringt ganz allgemein den erheblichen Vorteil mit sich, dass mit nur geringfügigem Aufwand ein großes Spektrum an Testfällen erprobt werden kann und auch veränderte Umgebungen des Steuergeräts - z. B. verschiedene Antriebsaggregate - simuliert werden können.

Es ist unmittelbar einleuchtend, dass ein solcher Simulator von einer Testschaltung - im hier verfolgten Beispiel von dem Motorsteuergerät - nicht nur Signale im Kleinsignalbereich erhält, sondern auch elektrische Großsignale, wenn die Testschaltung über leistungselektronische Ausgänge verfügt, wie dies beispielsweise bei der Ansteuerung von elektrischen Antrieben der Fall ist.

In der Praxis werden die bekannten Schaltungen zur Nachbildung einer elektrischen Last häufig derart betrieben, dass die Spannung am Ausgang der Testschaltung - also beispielsweise die Spannung am Ausgang des Leistungsteils eines Motorsteuergeräts - messtechnisch erfasst wird, in einem mathematischen Modell des zu simulierenden Motors ein entsprechender (Motor- )Strom berechnet wird, der über den Anschluss der Testschaltung unter Berücksichtigung der Betriebsdaten des Motors fließen müsste, und dieser Sollstromwert wird der Stromsteuereinheit übermittelt, welche dann den ermittelten Sollstrom möglichst zeitnah durch geeignete Ansteuerungen der Schaltung am Anschluss der Testschaltung einstellt.

Aus der WO 2007/04228 A1 ist beispielsweise eine Schaltung bekannt, bei der als elektrischer Energiespeicher eine Spule verwendet wird, die eine Induktivität aufweist, die deutlich kleiner ist als die Induktivität der Wicklung eines nachzubildenden Elektromotors. Üblicherweise sind zur Ansteuerung eines Elektromotors mehrere Anschlüsse erforderlich, weil derartige Antriebe mit größeren Leistungen mehrphasig - meist dreiphasig - anzusteuern sind. Am Anschluss der Testschaltung liegt typischerweise ein pulsweitenmoduliertes (PWM) Spannungssignal an, über dessen Tastverhältnis die an dem Anschluss im zeitlichen Mittel anliegende Spannung eingestellt werden kann. Die Spule ist mit ihrem anderen Anschluss über eine Halbbrücke mit zwei Hilfsspannungsquellen verbunden, so dass durch Schalten des einen Schalters der Halbbrücke dieser zweite Anschluss der Spule auf ein hohes Potential gelegt werden kann, und durch Schalten des anderen Schalters der Brücke der zweite Anschluss der Spule auf ein sehr niedriges Potential gelegt werden kann. So ist es möglich, den Stromfluss innerhalb der Spule zu beeinflussen und den Istwert des Stromes am Anschluss der Testschaltung auf den Wert eines vorgegebenen Sollstromes einzustellen bzw. zu regeln.

Die Spannungsquelle besteht im Stand der Technik aus der Versorgungsspannung der Testschaltung und zwei damit in Verbindung stehenden Hilfsspannungsquellen. Der Schaltung kann insgesamt Energie entzogen werden, indem eine der beiden Hilfsspannungsquellen so zugeschaltet wird, dass der Strom in der Spule reduziert wird.

Als Schalter der Halbbrücke werden üblicherweise Metalloxid-Semiconductor-Field-Effect-Transistoren (MOSFETs) eingesetzt, mit denen sich recht hohe Schaltfrequenzen erzielen lassen. Hohe Schaltfrequenzen der MOSFETs sind deshalb notwendig, da sich nur über eine hochfrequente Ansteuerung der Halbbrücke ein "glatter" Verlauf des Iststroms erzielen lässt. Die Schaltfrequenz der MOSFETs in der Halbbrücke ist aus diesem Grund sehr viel größer als die Frequenz des PWM-Spannungssignals am Ausgang der Testschaltung.

Sehr hohe Ströme und Spannungen sind von der Leistungsstufe der Testschaltung z. B. aufzubringen, wenn Antriebsaggregate von Pkw mit Elektroantrieb anzusteuern sind, wie sie in Hybrid- oder Elektro-Fahrzeugen zur Anwendung kommen. Solche Antriebe weisen nicht selten Leistungen im Bereich von einigen 10 kW bis etwa 100 kW auf. Gerade bei sehr dynamischen Belastungswechseln ist es hier notwendig, Spannungen am Anschluss der Testschaltung zu beherrschen, die im kV-Bereich liegen und Ströme, die im Bereich von einigen 10 A und in der Spitze auch mehreren 100 A liegen können.

Bei derart hohen Leistungen, die in der nachgebildeten elektrischen Last umzusetzen sind, geraten die vorbeschriebenen MOSFET-Schaltelemente jedoch an ihre Grenzen, da sie die beim Umschalten auftretenden Spannungen aufgrund einer zu geringen Spannungsfestigkeit nicht mehr zerstörungsfrei sperren können. Der Einsatz von robusteren Schaltelementen, wie z. B. IGBT-Transistoren (Insulated Gate Bipolar Transistor) ist nicht ohne weiteres möglich, da hier die benötigten hohen Schaltfrequenzen nicht erreicht werden.

Ein weiterer Nachteil bei einigen aus dem Stand der Technik bekannten Lösungen besteht darin, dass in der Schaltung zur Nachbildung einer Last vergleichsweise hohe Leistungen umgesetzt werden; hier ist es wünschenswert, Lösungen zu finden, die weniger (verlust)leistungsintensiv arbeiten.

Aufgabe der vorliegenden Erfindung ist es, die aufgezeigten Nachteile bei den bekannten Schaltungen zur Nachbildung einer elektrischen Last der hier in Rede stehenden Art - zumindest teilweise - zu vermeiden und insbesondere eine Schaltung anzugeben, die zur Nachbildung großer Lasten mit hohen Spannungen und Leistungsumsätzen geeignet ist.

Die erfindungsgemäße Schaltung zur Nachbildung einer elektrischen Last, bei der die zuvor hergeleitete und aufgezeigte Aufgabe gelöst ist, ist zunächst und im wesentlichen dadurch gekennzeichnet, dass in dem Brückenquerzweig eine steuerbare Spannungsquelle vorgesehen ist und der Iststrom iᵢₛₜ mittels einer auf die steuerbare Spannungsquelle wirkenden Stromsteuereinheit auf den Wert eines vorgegebenen Sollstroms iₛₒₗₗ einregelbar ist.

Durch die steuerbare Spannungsquelle in dem Brückenquerzweig ist es ohne weiteres möglich, den Iststrom iᵢₛₜ in Höhe und Richtung einzustellen. Dazu ist es natürlich erforderlich, dass die Stromsteuereinheit einerseits den Iststrom messtechnisch - wie auch immer realisiert - erfasst, mit dem Wert des vorgegebenen Sollstroms iₛₒₗₗ vergleicht und ein entsprechendes Stellsignal an die steuerbare Spannungsquelle weitergibt. Solange der erste Schalter und der zweite Schalter der Testschaltung sowie der dritte Schalter und der vierte Schalter der Schaltung so geschaltet sind, dass ein geschlossener Stromkreis unter Einbezug des Brückenquerzweiges resultiert, ist die steuerbare Spannungsquelle in dem Brückquerzweig wirksam. Es gibt nun verschiedene Möglichkeiten, die steuerbare Spannungsquelle in dem Brückenquerzweig zu realisieren.

Nach einer ersten Ausgestaltung der Erfindung ist vorgesehen, dass die von der steuerbaren Spannungsquelle bereitgestellte Spannung direkt über eine galvanische Kopplung in dem Brückenquerzweig eingekoppelt wird, wohingegen bei einer weiteren besonders bevorzugten Ausgestaltung der Erfindung vorgesehen ist, dass die von der steuerbaren Spannungsquelle bereitgestellte Spannung indirekt über eine induktive Kopplung in den Brückenquerzweig eingekoppelt wird, insbesondere nämlich über einen Transformator.

Bei der letztgenannten durch indirekte Einkopplung der steuerbaren Spannungsquelle bereitgestellten Spannung erfolgt die Regelung des Iststromes also primärseitig, wobei die Sekundärseite des Transformators in den Brückenquerzweig der H-Brückenschaltung eingebunden ist. Bei der Lösungsvariante mit induktiver Kopplung der steuerbaren Spannungsquelle ist zu beachten, dass über die steuerbare Spannungsquelle und die induktive Kopplung nur veränderliche Stromanteile im Brückenquerzweig geregelt werden können, da eine Gleichspannung mittels einer induktiven Kopplung nicht übertragbar ist. Die Regelung des Gleichspannung- bzw. des Gleichstromanteils muss dann durch geeignete Schaltungen des dritten Schalters und des vierten Schalters der Schaltung in Abhängigkeit des Schaltens des ersten und des zweiten Schalters der Testschaltung umgesetzt werden. Anhand dieser Überlegungen ist ersichtlich, dass es sich bei der steuerbaren Spannungsquelle um eine "schnell" steuerbare Spannungsquelle handeln muss, die jedenfalls so schnell sein muss, dass die transienten Stromanteile im Brückenquerzweig mit der gewünschten Einstellgeschwindigkeit eingeregelt werden können.

Eine bevorzugte Ausgestaltung der steuerbaren Spannungsquelle weist eine vierquadrantenfähige Umschaltvorrichtung mit einer internen Spannungsquelle auf, wobei diese interne Spannungsquelle insbesondere als Energiespeicher, bevorzugt als Kondensator ausgestaltet ist. Eine vierquadrantenfähige Umschaltvorrichtung ermöglicht, die interne Spannungsquelle in beliebiger Orientierung - Polarität - mit den äußeren Anschlusspunkten der Umschaltvorrichtung zu verbinden, so dass die interne Spannungsquelle ihre Anschlussspannung unterschiedlich in den Brückenquerzweig einbringen kann; dies gilt unabhängig davon, ob eine direkte oder eine indirekte Einkopplung der von der Spannungsquelle bereitgestellten Spannung vorgesehen ist. Bevorzugt ist dabei vorgesehen, dass die vierquadrantenfähige Umschaltvorrichtung einen ersten Schalter, einen zweiten Schalter, einen dritten Schalter und einen vierten Schalter umfasst, der erste Schalter mit dem zweiten Schalter über einen ersten Brückenanschluss verbunden ist, der zweite Schalter mit dem vierten Schalter verbunden ist, der vierte Schalter mit dem dritten Schalter über einen zweiten Brückenanschluss verbunden ist und der dritte Schalter mit dem ersten Schalter verbunden ist, wobei die interne Spannungsquelle mit der gemeinsamen Verbindung des ersten Schalters und des dritten Schalters verbunden ist und mit der gemeinsamen Verbindung des zweiten Schalters und des vierten Schalters verbunden ist, wobei bevorzugt vorgesehen ist, dass die interne Spannungsquelle ein Kondensator oder ein anderer Akkumulator oder eine andere elektronische Spannungsquelle wie z. B. ein DC/DC-Steller ist. Durch die interne Spannungsquelle wird daher die Spannungsquelle realisiert und durch die vierquadrantenfähigen Umschaltvorrichtungen ist die Steuerbarkeit der Spannungsquelle gewährleistet.

Bei der direkten Einkopplung der zuvor beschriebenen Vierquadranten-Umschaltvorrichtung in den Brückenquerzweig entsteht praktisch eine kaskadierte H-Brückenschaltung, wobei der erste und der zweite Schalter der Testschaltung und der dritte Schalter und der vierte Schalter der Schaltung die äußere H-Brücke bilden und die vier Schalter der vierquadrantenfähigen Umschaltvorrichtung die innere H-Brücke bilden. Nachteilig ist bei dieser Variante, dass die Umschaltvorrichtung beim Umschalten der äußeren H-Brücke auf einem springenden Potential liegt, wodurch beispielsweise parasitäre Kapazitäten wirksam werden und aufgrund der Potentialanhebung und -absenkung unerwünschte Ströme hervorgerufen werden, die zu einer Gleichtaktstörung führen. Dieses Problem ist dann gelöst, wenn die als vierquadrantenfähige Umschaltvorrichtung realisierte steuerbare Spannungsquelle induktiv in den Brückenzweig eingekoppelt ist, die vierquadrantenfähige Umschaltvorrichtung also nicht in galvanischem Kontakt mit dem Brückenquerzweig steht und dadurch auch bei Umschalten der Umschaltvorrichtung - äußere H-Brücke - keine springenden Potentiale an der Umschaltvorrichtung auftreten, so dass Gleichtaktstörungen hier weitestgehend vermieden werden können.

Eingangs ist gesagt worden, dass in dem Brückenquerzweig eine wirksame Induktivität vorgesehen ist, über die dann die Stromregelung erfolgt. Diese in dem Brückenquerzweig wirksame Induktivität kann schaltungstechnisch als separates Bauelement - also als Spule - realisiert sein, die wirksame Induktivität kann aber auch - oder zusätzlich - nicht als separates Bauteil realisiert sein, sondern schlicht als vorhandene parasitäre Streu- oder Leitungsinduktivität vorhanden sein. Wenn die steuerbare Spannungsquelle indirekt in den Brückenquerzweig einkoppelt, dann kann die in dem Brückenquerzweig wirksame Induktivität bauteilmäßig auch primärseitig in der steuerbaren Spannungsquelle als Spule vorliegen und/oder als Streuinduktivität des Transformators vorliegen und dennoch - aufgrund der induktiven Kopplung - als Induktivität in dem Brückenquerzweig wirksam sein. Insbesondere kann die Induktivität dann durch gezielte Auslegung als Streutransformator oder als Zweiwicklungsspule realisiert sein.

Insgesamt lässt sich die erfindungsgemäße Schaltung in einer bevorzugten Ausgestaltung in einem "leistungsneutralen" oder in einem "leistungsauf- oder abgebenden" Modus betreiben. In einer bevorzugten Ausgestaltung ist die Schaltung in dem leistungsneutralen Betrieb so eingerichtet, dass der dritte Schalter der Schaltung mit dem ersten Schalter der Testschaltung synchron betrieben wird und er vierte Schalter der Schaltung mit dem zweiten Schalter der Testschaltung synchron betrieben wird, wobei der erste Schalter der Testschaltung und der dritte Schalter der Schaltung im Gegentakt synchron zu dem zweiten Schalter der Testschaltung und dem vierten Schalter der Schaltung betrieben werden. Bei diesem Zusammenwirken der vier Schalter ist die Spannungsquelle unwirksam, da sie nicht in den geschlossenen Strompfad geschaltet ist, in dem der Brückenquerzweig liegt.

Dahingegen ist die Spannungsquelle in dem leistungsauf- oder -abgebenden Betrieb wirksam in den Brückenzweig geschaltet, so dass sie insgesamt den Stromfluss auch in dem Brückenquerzweig beeinflusst. Dazu wird entgegen der zuvor beschriebenen synchronen Betriebsweise kurzzeitig der dritte Schalter der Schaltung nicht synchron mit dem ersten Schalter der Testschaltung geschaltet und/oder wird der vierte Schalter der Schaltung nicht synchron mit dem zweiten Schalter der Testschaltung geschaltet, sondern mit einer gewissen Verzögerung, so dass eine zeitlich überlappende Betriebsweise des ersten Schalters der Testschaltung mit dem vierten Schalter der Schaltung bzw. des zweiten Schalters der Testschaltung mit dem dritten Schalter der Schaltung realisiert ist. Der leistungsauf- oder abgebende Betrieb kann im Falle, dass bei galvanischer Kopplung der steuerbaren Spannungsquelle die interne Spannungsquelle als Energiespeicher insbesondere als Kondensator oder Batterie realisiert ist, dazu verwendet werden, den Energiespeicher aufzuladen oder zu entladen. Dies ist näher beschrieben in der prioritätsbegründenden Patentanmeldung DE 10 2008 034 199.

In einer weiteren bevorzugten Ausgestaltung der Erfindung wird die Schaltung insgesamt so betrieben, dass insbesondere bei der induktiven Einkopplung der steuerbaren Spannungsquelle darauf geachtet wird, dass die beteiligten Spulen bzw. Transformatoren nicht in die magnetische Sättigung geraten, weil dann eine primärseitige Stromänderung keine Flussänderung mehr bewirkt und demzufolge auch sekundärseitig - also im Brückenquerzweig - keine Strom- bzw. Spannungsänderung bewirkt wird, so dass eine Regelung nicht mehr möglich ist. Dies geschieht bei einer bevorzugten Ausgestaltung der Schaltung dadurch, dass der leistungsauf- oder - abgebende Betrieb verwendet wird, um bei induktiver Kopplung der steuerbaren Spannungsquelle mit dem Brückenzweig eine drohende magnetische Sättigung der beteiligten Spulen / Transformatoren / Streuinduktivitäten zu verhindern, insbesondere wobei der Hauptinduktivitätsstrom der Spulen / Transformatoren, Streuinduktivitäten bevorzugt stets zu Null geregelt wird. Es ist für die Erfindung unwesentlich, wie die Erfassung des Hauptinduktivitätsstroms erfolgt.

EP 393847 beschreibt ein system zur Regelung einer Induktiven Last.

Im Einzelnen gibt es nun verschiedene Möglichkeiten, die erfindungsgemäße Schaltung zur Nachbildung einer elektrischen Last auszugestalten und weiterzubilden. Dazu wird verwiesen auf die dem Patentanspruch 1 nachgeordneten Patentansprüche und auf die Beschreibung bevorzugter Ausführungsbeispiele in Verbindung mit der Zeichnung. In der Zeichnung zeigen
- Fig. 1: ein Prinzipschaltbild der erfindungsgemäßen Schaltung zur Nachbildung einer elektrischen Last,
- Fig. 2: ein weiteres Prinzipschaltbild einer weiteren erfindungsgemäßen Schaltung zur Nachbildung einer elektrischen Last mit induktiver Spannungseinkopplung,
- Fig. 3: ein Schaltbild einer erfindungsgemäßen Schaltung, bei der die steuerbare Spannungsquelle als vierquadrantenfähige Umschaltvorrichtung mit einer internen Spannungsquelle realisiert ist,
- Fig. 4: eine Schaltung, die hinsichtlich der Realisierung der gesteuerten Spannungsquelle mit Fig. 3 vergleichbar ist, jedoch mit induktiv eingekoppelter gesteuerter Spannung,
- Fig. 5: das Schaltbild einer erfindungsgemäßen Schaltung, bei der die im Brückenquerzweig wirksame Induktivität bei induktiver Einkopplung der gesteuerten Spannung primärseitig verwirklicht ist,
- Fig. 6: das Schaltbild einer erfindungsgemäßen Schaltung, bei der die steuerbare Spannungsquelle als Halbbrücken-Endstufe realisiert ist,
- Fig. 7: das Schaltbild einer weiteren erfindungsgemäßen Schaltung bei der die steuerbare Spannung über einen Dreiwicklungstransformator transformatorisch eingekoppelt wird,
- Fig. 8: das Schaltbild einer weiteren erfindungsgemäßen Schaltung mit induktiver Einkopplung,
- Fig. 9: das Schaltbild einer erfindungsgemäßen Schaltung gemäß Fig. 8, wobei die Gleichtaktunterdrückung spannungsgesteuert erfolgt und
- Fig. 10: ein schematisches Schaltbild der erfindungsgemäßen Schaltung im Dreiphasenbetrieb.

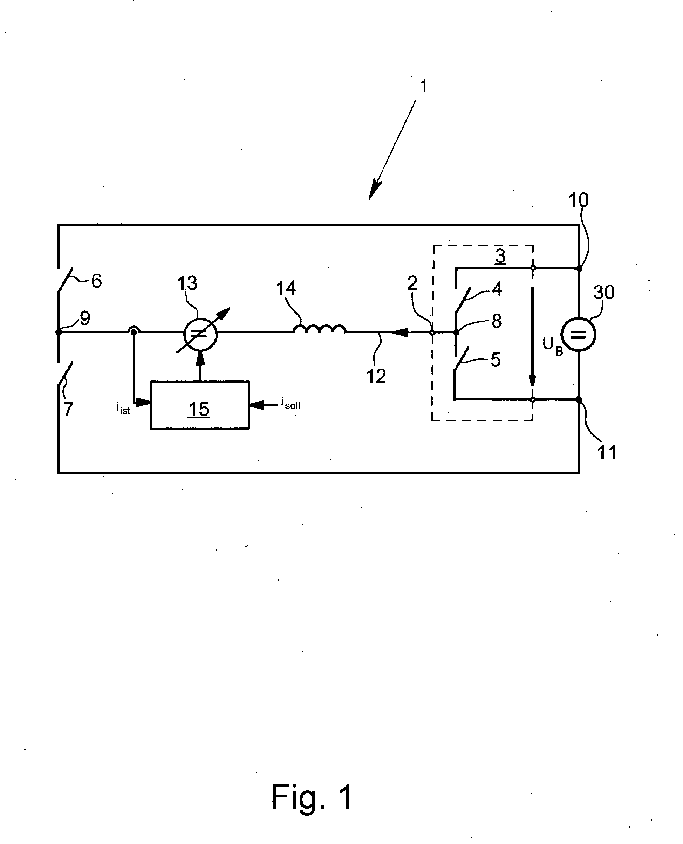

Alle in den Fig. 1 bis 10 dargestellten Schaltungen 1 dienen zur Nachbildung einer elektrischen Last. Diese elektrische Last soll an einem Anschluss 2 einer Testschaltung 3 nachgebildet werden, um die Testschaltung 3 zu testen. Bei der Testschaltung 3 handelt es sich üblicherweise um ein zu testendes Steuergerät, was dann häufig auch als DUT (Device Under Test) bezeichnet wird. Die Testschaltung 3 weist wenigstens einen ersten Schalter 4 und einen zweiten Schalter 5 auf, die Schaltung 1 weist einen dritten Schalter 6 und einen vierten Schalter 7 auf, wobei der erste Schalter 4 und der zweite Schalter 5 der Testschaltung 3 über einen gemeinsamen ersten inneren Verbindungspunkt 8 mit dem Anschluss 2 der Testschaltung 3 verbunden sind, und der dritte Schalter 6 und der vierte Schalter 7 über einen gemeinsamen inneren Verbindungspunkt 9 miteinander verbunden sind. Der erste Schalter 4 und der zweite Schalter 5 der Testschaltung 3 deuten hier die Endstufe der Testschaltung 3 an, wobei derartige Endstufen von Testschaltungen über den interessierenden Anschluss 2 häufig PWM-Spannungssignale ausgeben, die mittels einer zwei Schalter umfassenden Halbbrücke generiert werden, wie das auch mit den hier dargestellten Testschaltungen 3 möglich ist. Der dritte Schalter 6 und der vierte Schalter 7 der Schaltung sind über eine Regeleinrichtung (in der Figur nicht gezeigt) regelbar, insbesondere in Abhängigkeit des Betriebs des ersten Schalters 4 und des zweiten Schalters 5 der Testschaltung 3. Der erste Schalter 4 und der zweite Schalter 5 der Testschaltung 3 sind gegeneinander verriegelt, d.h. diese Schalter 4, 5 können nicht gleichzeitig dieselbe Schalterstellung einnehmen. Ebenso können der dritte Schalter 6 und der vierte Schalter 7 der Schaltung 1 nicht gleichzeitig geschaltet werden.

Der erste Schalter 4 und der dritte Schalter 6 sind über einen ersten äußeren Verbindungspunkt 10 miteinander verbunden und der zweite Schalter 5 ist mit dem vierten Schalter 7 über einen zweiten äußeren Verbindungspunkt 11 verbunden. Der erste äußere Verbindungspunkt 10 und der zweite äußere Verbindungspunkt 11 sind von einer Spannungsquelle 30 mit einer Versorgungsspannung U_{B} beaufschlagt und der über den Anschluss der Testschaltung 3 fließende Iststrom iᵢₛₜ fließt über den zwischen dem Anschluss 2 und dem zweiten Verbindungspunkt 9 ausgebildeten Brückenquerzweig 12. Der erste Schalter 4, der zweite Schalter 5, der dritte Schalter 6 und der vierte Schalter 7 bilden folglich zusammen mit dem Brückenquerzweig 12 eine H-Brückenschaltung.

Um eine Last tatsächlich am Anschluss 2 der Testschaltung 3 nachbilden zu können, muss der Iststrom iᵢₛₜ auf einen Vorgabewert geregelt werden, was in allen in den Fig. 1 bis 10 dargestellten Ausführungsbeispielen dadurch realisiert ist, dass in dem Brückenquerzweig 12 eine steuerbare Spannungsquelle 13 und eine in dem Brückenquerzweig 12 wirksame Induktivität 14 vorgesehen ist, und der Iststrom iᵢₛₜ mittels einer auf die steuerbare Spannungsquelle 13 wirkenden Stromsteuereinheit 15 auf den Wert eines vorgegebenen Sollstroms iₛₒₗₗ einregelbar ist.

Bei dem Ausführungsbeispiel gemäß Fig. 1 ist die steuerbare Spannungsquelle 13 direkt in dem Brückenquerzweig 12 angeordnet, so dass die von der steuerbaren Spannungsquelle 13 bereitgestellte Spannung direkt über eine galvanische Kopplung in den Brückenquerzweig 12 einspeisbar ist. Es ist ohne weiteres einzusehen, dass durch Variation der von der steuerbaren Spannungsquelle 13 bereitgestellten Spannung der Stromfluss in dem Brückenquerzweig 12 direkt beeinflusst werden kann und durch übliche Regler auf den Wert eines vorgegebenen Sollstroms iₛₒₗₗ einregelbar ist.

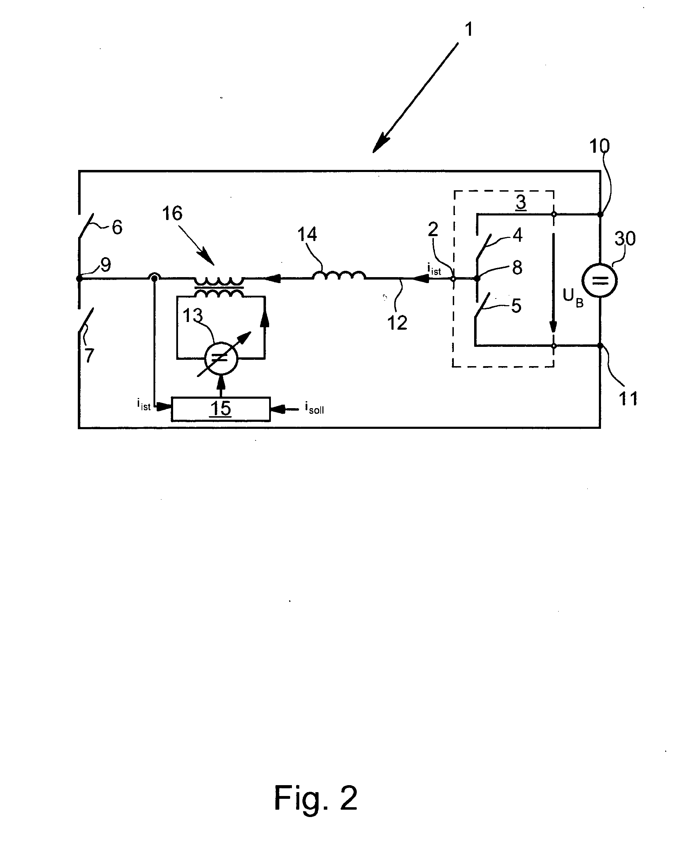

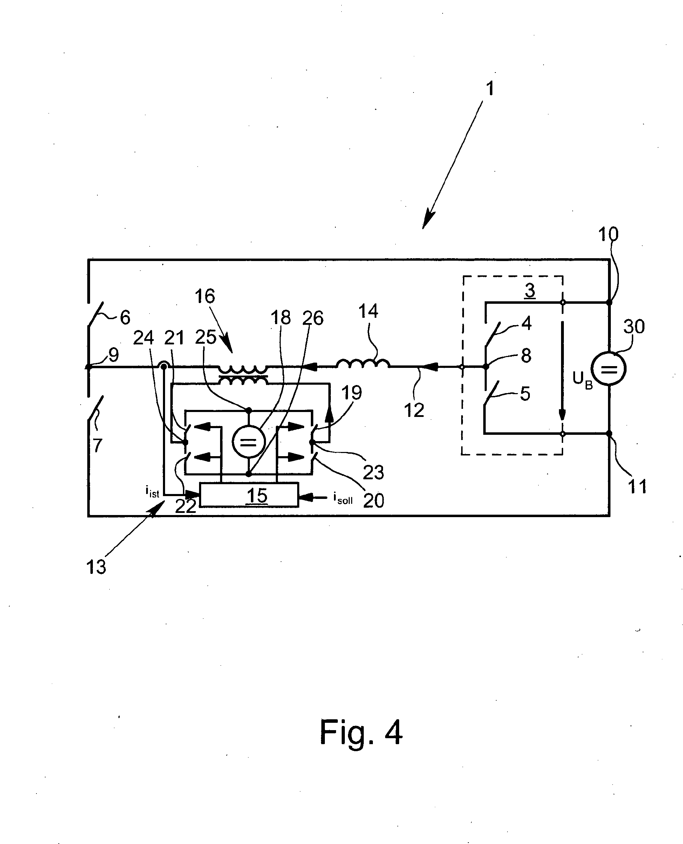

Bei der Schaltung gemäß Fig. 2 wird die von der steuerbaren Spannungsquelle 13 bereitgestellte Spannung indirekt über eine induktive Kopplung in den Brückenquerzweig 12 eingekoppelt, wobei die induktive Kopplung vorliegend durch einen Transformator 16 realisiert ist. Die von der Stromsteuereinheit 15 gesteuerte Spannungsquelle 13 beeinflusst also den primärseitigen Strom des Transformators 16, wobei der Transformator 16 den Strom - bzw. die über die primärseitig erzielte Stromänderung erzeugte Spannung - sekundärseitig in den Brückenquerzweig 12 überträgt. Da es ganz grundsätzlich über eine induktive Kopplung nur möglich ist, Wechselströme zu übertragen, kann mit der indirekt wirkenden steuerbaren Spannungsquelle 13 gemäß Fig. 2 nur Einfluss auf Wechselanteile des Stroms in dem Brückenquerzweig genommen werden. Die Regelung des Gleichanteils des in dem Brückenquerzweig 12 fließenden Laststromes erfolgt dann über geeignete Schaltung des ersten Schalters 6 und des zweiten Schalters 7 der Schaltung 1 bezüglich des ersten Schalters 4 und des zweiten Schalters 5 der Testschaltung 3, wobei das Verhalten des ersten Schalters 4 und des zweiten Schalters 5 der Testschaltung 3 nicht im Sinne einer aktiven Steuerung beeinflussbar ist, sondern von der Testschaltung 3 bestimmt wird. Die induktive Einkopplung der von der steuerbaren Spannungsquelle 13 bereitgestellten Spannung ist ferner auch realisiert in den Ausführungsbeispielen gemäß den Fig. 4 bis 9.

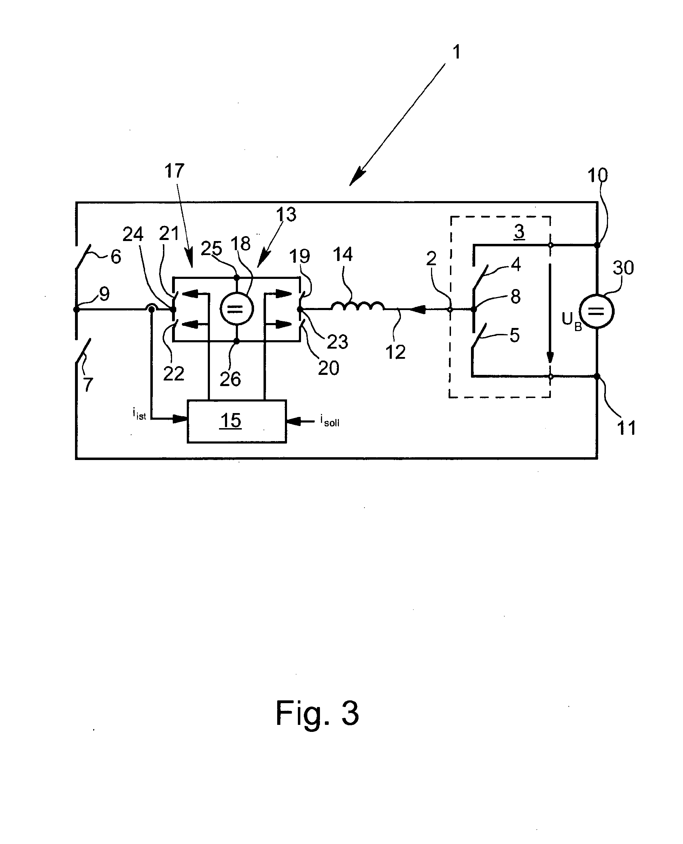

Die Fig. 3 und 4 zeigen eine besondere Realisierung der steuerbaren Spannungsquelle 13 mit einer vierquadrantenfähigen Umschaltvorrichtung 17, die eine interne Spannungsquelle 18 aufweist. Durch die Vierquadrantenfähigkeit der Umschaltvorrichtung 17 ist es möglich, die interne Spannungsquelle 18 in verschiedenen Orientierungen in dem Brückenquerzweig 12 wirksam werden zu lassen, unabhängig davon, ob die steuerbare Spannungsquelle 13 in Form der vierquadrantenfähigen Umschaltvorrichtung 17 direkt oder induktiv in den Brückenquerzweig 12 eingekoppelt ist.

Die vierquadrantenfähige Umschaltvorrichtung 17 weist jedenfalls einen ersten Schalter 19, einen zweiten Schalter 20, einen dritten Schalter 21 und einen vierten Schalter 22 auf, wobei der erste Schalter 19 mit dem zweiten Schalter 20 über einen ersten Brückenanschluss 23 verbunden ist und der zweite Schalter 20 mit dem vierten Schalter 22 verbunden ist, der vierte Schalter 22 mit dem dritten Schalter 21 über einen zweiten Brückenanschluss 24 verbunden ist und der dritte Schalter 21 ebenfalls mit dem ersten Schalter 19 verbunden ist, wobei die interne Spannungsquelle 18 mit der gemeinsamen Verbindung 25 des ersten Schalters 19 und des dritten Schalters 21 verbunden ist und die interne Spannungsquelle 18 zusätzlich mit der gemeinsamen Verbindung 26 des zweiten Schalters 20 und des vierten Schalters 22 verbunden ist.

Über den ersten Brückenanschluss 23 und den zweiten Brückenanschluss 24 ist die vierquadrantenfähige Umschaltvorrichtung 17 in den Brückenquerzweig 12 wirksam eingekoppelt. In der Schaltung gemäß Fig. 3 bildet sowohl die vierquadrantenfähige Umschaltvorrichtung 17 eine H-Brückenschaltung als auch - wie vorausgesetzt - die Schaltung bestehend aus dem ersten Schalter 4, dem zweiten Schalter 5, dem dritten Schalter 6 und dem vierten Schalter 7, so dass die dargestellte Schaltung 1 insgesamt als kaskadierte H-Brückenschaltung bezeichnet werden kann. Durch gleichzeitiges Schließen des ersten Schalters 19 und des vierten Schalters 22 der Umschaltvorrichtung 17 bei gleichzeitigem Öffnen des zweiten Schalters 20 und des dritten Schalters 21 der Umschaltvorrichtung 17 kann die interne Spannungsquelle 18 in einer ersten Orientierung in den Brückenquerzweig 12 eingekoppelt werden und bei einer genau gegensinnigen Öffnung bzw. Schließung der Schalter 19, 20, 21 und 22 kann die interne Spannungsquelle 18 in einer dazu entgegengesetzten Orientierung in den Brückenquerzweig 12 eingekoppelt und wirksam werden.

Zum Ausgleich von immer vorhandenen elektrischen Verlusten und zur Veränderung des über den Anschluss 2 der Testschaltung 3 fließenden Laststromes in einem größeren Maßstab, der von der steuerbaren Spannungsquelle 13 nicht mehr geleistet werden kann, ist es erforderlich, die äußere H-Brückenschaltung einzusetzen, die gebildet wird aus dem ersten Schalter 4 und dem zweiten Schalter 5 der Testschaltung 3 und dem ersten Schalter 6 und dem zweiten Schalter 7 der Schaltung 1 sowie aus dem Brückenquerzweig 12 zwischen dem Anschluss 2 der Testschaltung 3 und dem zweiten inneren Verbindungspunkt 9. Dazu ist vorgesehen, dass die Schaltungen 1 in einem leistungsauf- oder -abbauenden Modus betrieben werden können oder aber in einem leistungsneutralen Betrieb, bei dem eine Regelung "im kleinen" ausschließlich über die steuerbare Spannungsquelle 13 im Zusammenhang mit der Stromsteuereinheit 15 erfolgt. Zur Implementierung des leistungsneutralen Betriebes sind die dargestellten Schaltungen 1 so eingerichtet, dass der dritten Schalter 6 der Schaltung 1 mit dem ersten Schalter 4 der Testschaltung 3 synchron betrieben wird und der vierten Schalter 7 der Schaltung 1 mit dem zweiten Schalter 5 der Testschaltung 3 synchron betrieben wird, wobei der erste Schalter 4 der Testschaltung 3 und der dritte Schalter 6 der Schaltung 1 im Wesentlichen im Gegentakt synchron zu dem zweiten Schalter 5 der Testschaltung 3 und dem vierten Schalter 7 der Schaltung 1 betrieben wird. In diesem Modus können nur zwei Stromkreise realisiert werden, in denen die Spannungsquelle 30 nicht wirksam ist.

Dahingegen ist der leistungsauf- oder abbauende Betrieb bei den dargestellten Schaltungen 1 dadurch realisiert, dass die Spannungsquelle 30 wirksam in den Brückenquerzweig 12 geschaltet wird, nämlich indem der dritte Schalter 6 der Schaltung 1 nicht synchron mit dem ersten Schalter 4 der Testschaltung 3 geschaltet wird bzw. der vierte Schalter 7 der Schaltung 1 nicht synchron mit dem zweiten Schalter 5 der Testschaltung 3 geschaltet, sondern mit einer gewissen Verzögerung, so dass eine leicht verzögerte Betriebsweise der Schalter 4 und 6 bzw. der Schalter 5 und 7 resultiert und somit eine zeitlich überlappende Betriebsweise der Schalter 4 und 7 bzw. 5 und 6 realisiert ist. Dadurch ist stets die Spannungsquelle 30 in Serie mit dem Brückenquerzweig 12 geschaltet und wirkt so - je nach Polarität - im Brückenquerzweig 12 strommindernd oder stromverstärkend. Der leistungsauf- oder abgebende Betrieb wird vorliegend bei der galvanischen Kopplung der steuerbaren Spannungsquelle 13 und bei der dargestellten Realisierung der internen Spannungsquelle 18 als Energiespeicher in Form eines Kondensators dazu verwendet, den Energiespeicher aufzuladen oder zu entladen (siehe auch DE 10 2008 034 199).

In den Fig. 1 bis 4 und 6 bis 9 ist die in dem Brückenquerzweig 12 wirksame Induktivität 14 jeweils als Spule realisiert. In anderen, hier nicht dargestellten Ausführungsbeispielen, ist es jedoch ausreichend, wenn die in dem Brückenquerzweig 12 wirksame Induktivität 14 parasitär als Streu- oder Leitungsinduktivität realisiert ist, d. h. als Bauteil überhaupt nicht in Erscheinung tritt.

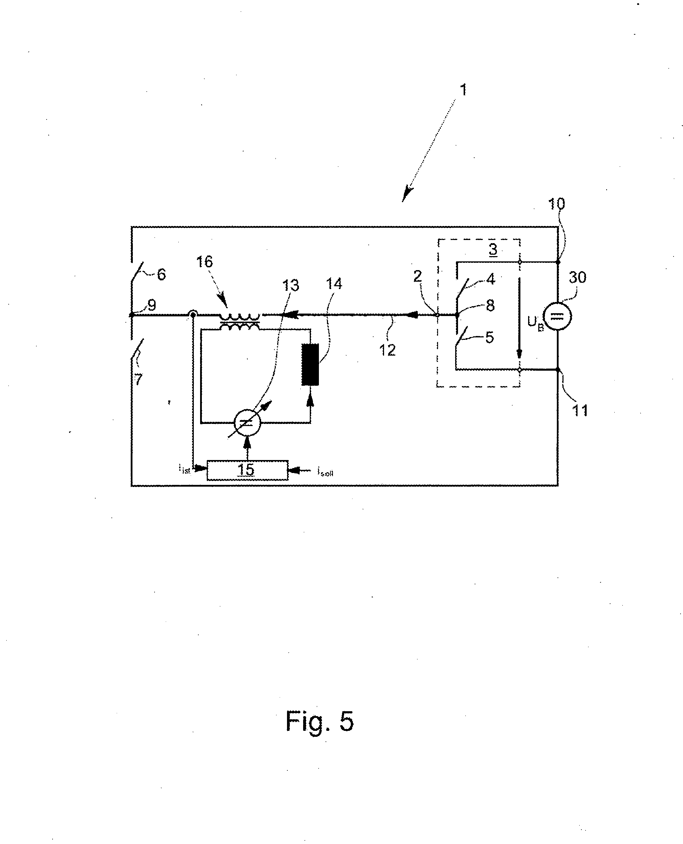

In dem Ausführungsbeispiel gemäß Fig. 5 ist die in dem Brückenquerzweig 12 wirksame Induktivität 14 primärseitig in der steuerbaren Spannungsquelle 13 als Spule realisiert, wobei damit natürlich auch gemeint ist, dass die Spule nicht als Einheit mit der Spannungsquelle 13 ausgebildet sein muss, sondern vielmehr in dem Stromkreis angeordnet ist, in dem die steuerbare Spannungsquelle 13 wirksam ist, so wie dies in Fig. 5 auch dargestellt ist.

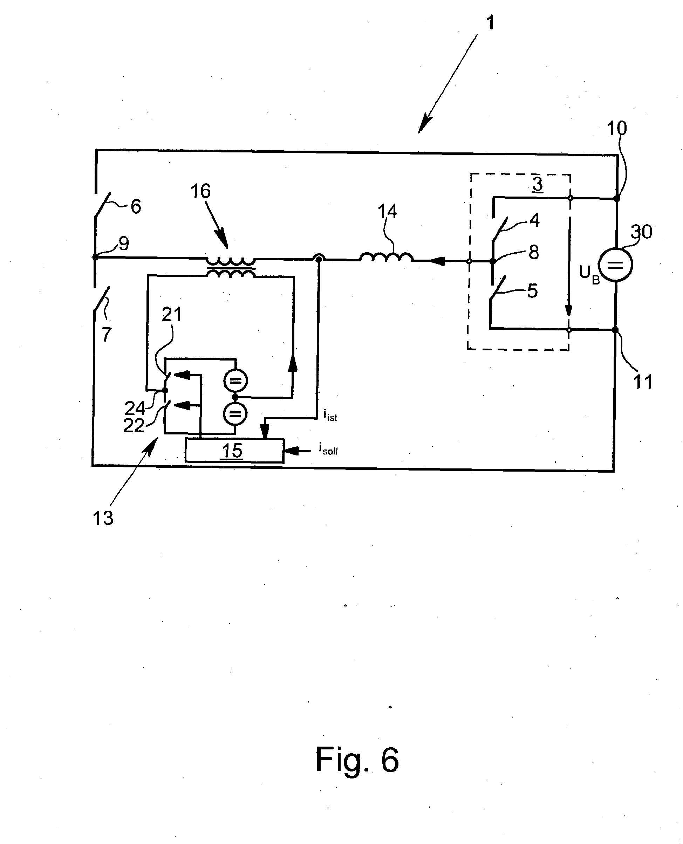

In dem Ausführungsbeispiel gemäß Fig. 6 ist die steuerbare Spannungsquelle 13 nicht als vollständige H-Brückenschaltung realisiert, sondern vielmehr als Halbbrücke mit zwei internen Spannungsquellen, die in ihrem Aufbau und ihrer Ansteuerung weniger aufwendig ist als die Lösung mit einer Vollbrücke.

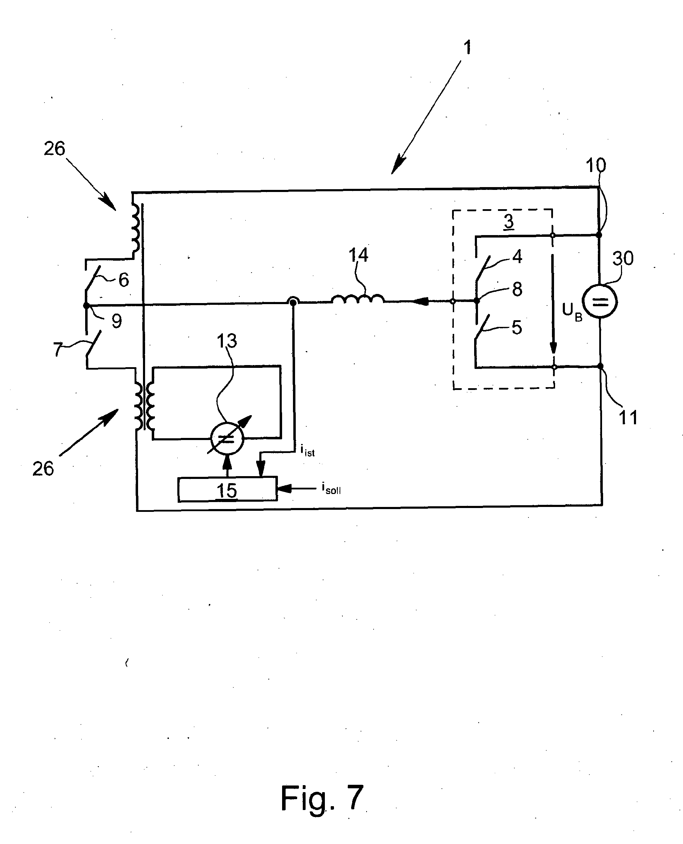

Die in Fig. 7 dargestellte Lösungsvariante beeinflusst den Strom in dem Brückenquerzweig 12 durch Einflussnahme auf den in jeweils einem der beiden möglichen Stromkreise der H-Brückenschaltung fließenden Ströme, wobei vorliegend wegen des einfachen Aufbaus ein Dreiwicklungstransformator 26 verwendet wird. Hierdurch wird vermieden, dass die Primärseite des zur Steuerung verwendeten Transformators sich auf einem springenden Potential befindet.

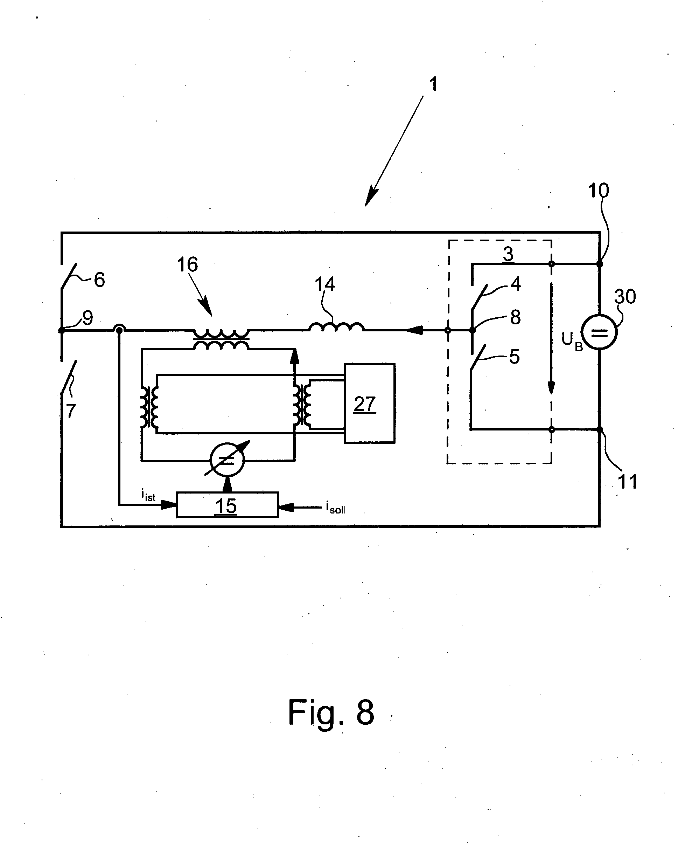

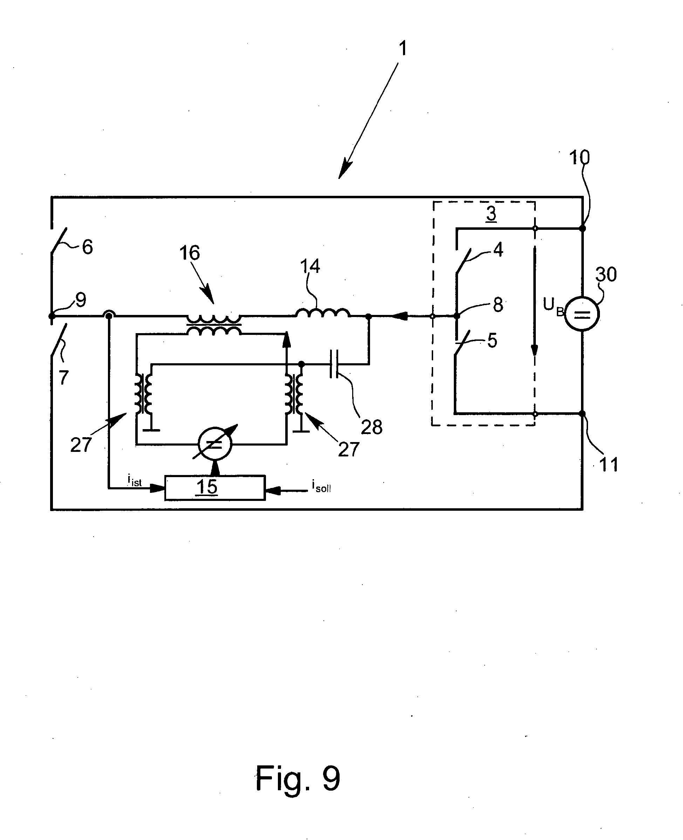

Bei der Schaltung gemäß Fig. 8 ist eine aktive Gleichtaktunterdrückung durch eine Ansteuerung 27 realisiert, was auch in der Variante gemäß Fig. 9 realisiert ist, hier jedoch unter Verwendung der an dem Anschluss 2 der Testschaltung 3 anliegenden Spannung, wobei über den Koppelkondensator 28 eine Unterdrückung des Gleichanteils bewirkt wird.

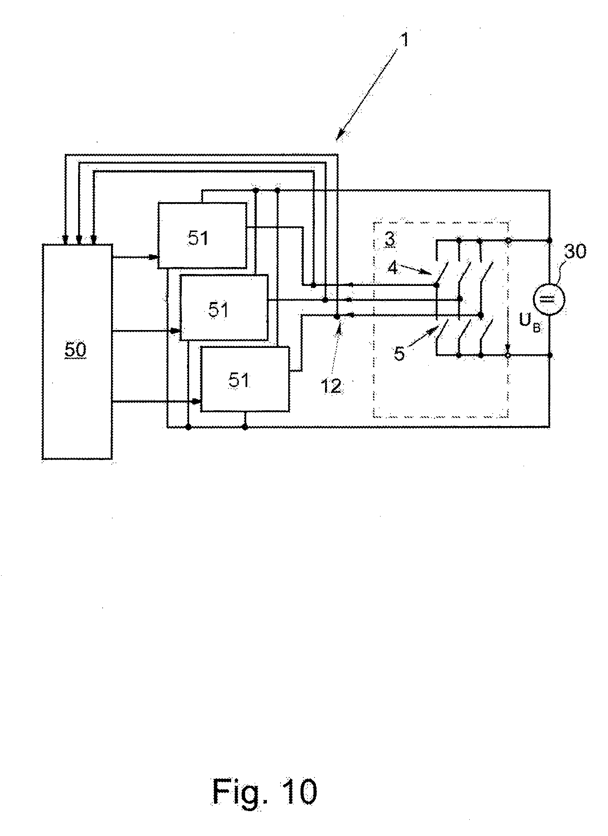

In Fig. 10 ist grundsätzlich dargestellt, dass die erfindungsgemäße Schaltung 1 zur Nachbildung einer elektrischen Last selbstverständlich nicht nur einphasig eingesetzt werden kann - also zur Einstellung nur eines einzigen Strompfades an nur einem Anschluss bzw. Anschlusspaar einer Testschaltung -, sondern die Schaltung ohne weiteres auch bei solchen Anwendungsfällen einsetzbar ist, bei denen eine mehrphasige elektrische Last nachzubilden ist. Hier wird für jede nachzubildende Phase eine erfindungsgemäße Schaltung zur Nachbildung einer Last vorgesehen. Die Schaltungen können ohne weiteres verwendet werden, wenn die nachzubildende Last über einen zentralen Anschlusspunkt ("Sternpunkt") verfügt. Das Simulationsmodell stellt in diesem Fall sicher, dass der Summenstrom über alle angeschlossenen Phasen gleich Null ist.

In Fig. 10 ist auch dargestellt, wie ein Simulationsmodell 50 eines Elektromotors aus den an den Phasen gemessenen Spannungen die Ströme der realen Last berechnet und diese als Stromsollwerte dem eigentlichen Lastteil 51 der erfindungsgemäßen Schaltungen 1 aufschaltet. Der eigentliche Lastteil 51 der erfindungsgemäßen Schaltungen 1 ist entsprechend der mehrphasigen-hier dreiphasigen - Anordnung mehrfach - hier dreifach - vorhanden und umfasst unabhängig von der jeweiligen Realisierungsvariante der Schaltung 1 im wesentlichen jeweils die Schalter 6 und 7, die steuerbare Spannungsquelle 13, die wirksame Induktivität 14 und die Stromsteuereinheit 15. Dabei werden die durch das Simulationsmodell 50 erzeugten Stromsollwerte entsprechend den vorherigen Ausführungen jeweils der im eigentliche Lastteil 51 enthaltenen Stromsteuereinheit 15 aufgeschaltet, welche den Strom in den Phasen ausregelt.

## Patentansprüche

1. Schaltung zur Nachbildung einer elektrischen Last an einem Anschluss (2) einer Testschaltung (3), wobei die Testschaltung (3) wenigstens einen ersten Schalter (4) und einen zweiten Schalter (5) aufweist, wobei die Schaltung (1) einen dritten Schalter (6) und einen vierten Schalter (7) aufweist, der erste Schalter (4) und der zweite Schalter (5) der Testschaltung (3) über einen gemeinsamen ersten inneren Verbindungspunkt 8 mit dem Anschluss (2) der Testschaltung (3) verbunden sind, der dritte Schalter (6) und der vierte Schalter (7) über einen gemeinsamen zweiten inneren Verbindungspunkt (9) miteinander verbunden sind, der erste Schalter (4) und der dritte Schalter (6) über einen ersten äußeren Verbindungspunkt (10) miteinander verbunden sind und der zweite Schalter (5) mit dem vierten Schalter (7) über einen zweiten äußeren Verbindungspunkt (11) miteinander verbunden, so dass der erste Schalter (4), der zweite Schalter (5), der dritte Schalter (6) und der vierte Schalter (7) eine H-Brückenschaltung bilden, der erste äußere Verbindungspunkt (10) und der zweite äußere Verbindungspunkt (11) von einer Spannungsquelle (30) mit einer Versorgungsspannung U_{B} beaufschlagt sind und der über den Anschluss (2) der Testschaltung (3) fließende Iststrom iᵢₛₜ über den zwischen dem Anschluss (2) und dem zweiten Verbindungspunkt (9) ausgebildeten Brückenquerzweig (12) fließt, wobei eine in dem Brückenquerzweig (12) wirksame Induktivität (14) vorgesehen ist,
**dadurch gekennzeichnet,**
**dass** in dem Brückenquerzweig (12) eine steuerbare Spannungsquelle (13) vorgesehen ist und der Iststrom iᵢₛₜ mittels einer auf die steuerbare Spannungsquelle (13) wirkenden Stromsteuereinheit (15) auf den Wert eines vorgegebenen Sollstroms iₛₒₗₗ einregelbar ist.

2. Schaltung nach Anspruch 1, **dadurch gekennzeichnet, dass** die von der steuerbaren Spannungsquelle (13) bereitgestellte Spannung direkt über eine galvanische Kopplung in den Brückenquerzweig (12) eingekoppelt wird.

3. Schaltung nach Anspruch 1, **dadurch gekennzeichnet, dass** die von der steuerbaren Spannungsquelle (13) bereitgestellte Spannung indirekt über eine induktive Kopplung in den Brückenquerzweig (12) eingekoppelt wird, insbesondere über wenigstens einen Transformator (16).

4. Schaltung nach einem der Ansprüche 1 bis 3, **dadurch gekennzeichnet, dass** die steuerbare Spannungsquelle (13) realisiert ist durch eine vierquadrantenfähige Umschaltvorrichtung (17) mit einer internen Spannungsquelle (18), insbesondere einem Energiespeicher, bevorzugt mit einem Kondensator.

5. Schaltung nach Anspruch 4, **dadurch gekennzeichnet, dass** die vierquadrantenfähige Umschaltvorrichtung (17) einen ersten Schalter (19), einen zweiten Schalter (20), einen dritten Schalter (21) und einen vierten Schalter (22) umfasst, der erste Schalter (19) mit dem zweiten Schalter (20) über einen ersten Brückenanschluss (23) verbunden ist, der zweite Schalter (20) mit dem vierten Schalter (22) verbunden ist, der vierte Schalter (22) mit dem dritten Schalter (21) über einen zweiten Brückenanschluss (24) verbunden ist und der dritte Schalter (21) mit dem ersten Schalter (19) verbunden ist, wobei die interne Spannungsquelle (18) mit der gemeinsamen Verbindung (25) des ersten Schalters (19) und des dritten Schalters (21) verbunden ist und mit der gemeinsamen Verbindung (26) des zweiten Schalters (20) und des vierten Schalters (22) verbunden ist, insbesondere wobei die interne Spannungsquelle (18) ein Kondensator ist.

6. Schaltung nach einem der Ansprüche 1 bis 5, **dadurch gekennzeichnet, dass** die in dem Brückenquerzweig (12) wirksame Induktivität (14) als Spule realisiert ist und/oder parasitär als Streu- oder Leitungsinduktivität realisiert ist.

7. Schaltung nach den Ansprüchen 6 und 3, **dadurch gekennzeichnet, dass** die in dem Brückenquerzweig (12) wirksame Induktivität (14) als Streuinduktivität des Transformators (16) vorliegt, insbesondere durch gezielte Auslegung als Streutransformator oder als Zweiwicklungsspule.

8. Schaltung nach einem der Ansprüche 1 bis 7, **dadurch gekennzeichnet, dass** in einem leistungsneutralen Betrieb die Schaltung so eingerichtet ist, dass der dritte Schalter (6) der Schaltung mit dem ersten Schalter (4) der Testschaltung synchron betrieben wird und der vierte Schalter (7) der Schaltung mit dem zweiten Schalter (5) der Testschaltung synchron betrieben wird, wobei der erste Schalter (4) der Testschaltung (3) und der dritte Schalter (6) der Schaltung (1) im Gegentakt synchron zu dem zweiten Schalter (5) der Testschaltung (3) und dem vierten Schalter (7) der Schaltung (1) betrieben werden.

9. Schaltung nach einem der Ansprüche 1 bis 7, **dadurch gekennzeichnet, dass** in einem leistungsauf- oder -abbauenden Betrieb die Spannungsquelle (30) wirksam in den Brückenquerzweig (12) geschaltet wird, insbesondere indem kurzzeitig der dritte Schalter (6) der Schaltung nicht synchron mit dem ersten Schalter (4) der Testschaltung geschaltet ist und/oder der vierte Schalter (7) der Schaltung nicht synchron mit dem zweiten Schalter (5) der Testschaltung geschaltet ist, sondern mit einer gewissen Verzögerung.

10. Schaltung nach Anspruch 9, **dadurch gekennzeichnet, dass** der leistungsauf- oder-abbauenden Betrieb verwendet wird, um bei induktiver Kopplung der steuerbaren Spannungsquelle (13) mit dem Brückenquerzweig (12) eine drohende magnetische Sättigung der beteiligten Spulen/Transformatoren/ Streuinduktivitäten zu verhindern, insbesondere wobei der Hauptinduktivitätsstrom der Spulen/Transformatoren/Streuinduktivitäten bevorzugt zu Null geregelt wird.

11. Schaltung nach Anspruch 9, **dadurch gekennzeichnet, dass** der leistunsauf- oder -abbauende Betrieb verwendet wird, um bei galvanischer Kopplung der steuerbaren Spannungsquelle (13) in den Brückenzweig (12) den Energiespeicher aufzuladen oder zu entladen, insbesondere wobei die steuerbare Spannungsquelle (13) als vierquadrantenfähige Umschaltvorrichtung ausgelegt ist, wobei bevorzugt die interne Spannungsquelle als Energiespeicher in Form eines Kondensators oder einer Batterie ausgestaltet ist.

## Claims

1. A circuit for emulating an electrical load at a connection (2) of a test circuit (3), the test circuit (3) comprising at least one first switch (4) and one second switch (5), the circuit (1) comprising a third switch (6) and a fourth switch (7), the first switch (4) and the second switch (5) of the test circuit (3) being connected to the connection of the test circuit (4) by means of a common first internal connection point (8), the third switch (6) and the fourth switch (7) being connected to each other by means of a common second internal connection point (9), the first switch (4) and the third switch (6) being connected to each other by means of a first external connection point (10) and the second switch (5) being connected to the fourth switch (7) by means of a second external connection point (11), so that the first switch (4), the second switch (5), the third switch (6), and the fourth switch (7) form an H-bridge circuit, the first external connection point (10) and the second external connection point (11) being supplied with a supply voltage U_{B} by a voltage source (30) and the actual current iᵢₛₜ flowing through the connection (2) of the test circuit (3) flowing through the traverse bridge branch (12) formed between the connection (2) and the second connection point (9), an effective inductance (14) being provided in the bridge shunt circuit (12),
**characterized in that**
a controllable voltage source (13) is provided in the traverse bridge branch (12) and the actual current iᵢₛₜ can be regulated to the level of a specified target current iₛₒₗₗ by means of a current controller (15) acting on the controllable voltage source (13).

2. The circuit according to claim 1, **characterized in that** the voltage provided by the controllable voltage source (13) is coupled to the traverse bridge branch circuit (12) directly by means of a galvanic coupling.

3. The circuit according to claim 1, **characterized in that** the voltage provided by the controllable voltage source (13) is coupled to the traverse bridge branch (12) indirectly by means of an inductive coupling, particularly by means of at least one transformer (16).

4. The circuit according to any one of the claims 1 through 3, **characterized in that** the controllable voltage source (13) is implemented by means of a four-quadrant-capable switchover device (17) having an internal voltage source (18), particularly an energy store, preferably having a capacitor.

5. The circuit according to claim 4, **characterized in that** the four-quadrant-capable switchover device (17) comprises a first switch (19), a second switch (20), a third switch (21), and a fourth switch (22), the first switch (19) is connected to the second switch (20) by means of a first bridge connection (23), the second switch (20) is connected to the fourth switch (22), the fourth switch (22) is connected to the third switch (21) by means of a second bridge connection (24), and the third switch (21) is connected to the first switch (19), wherein the internal voltage source (18) is connected to the common connection (25) of the first switch (19) and the third switch (21) and to the common connection (26) of the second switch (20) and the fourth switch (22), particularly wherein the internal voltage source (18) is a capacitor.

6. The circuit according to any one of the claims 1 through 5, **characterized in that** the inductance (14) effective in the traverse bridge branch (12) is implemented as a coil and/or is implemented parasitically as a leakage inductance and/or a line inductance.

7. The circuit according to the claims 6 and 3, **characterized in that** the inductance (14) effective in the traverse bridge branch (12) is present as a leakage inductance of the transformer (16), particularly by specifically designing the same as a leakage transformer or a double-wound coil.

8. The circuit according to any one of the claims 1 through 7, **characterized in that** the circuit is set up in neutral power operation so that the third switch (6) of the circuit is operated synchronously with the first switch (4) of the test circuit and the fourth switch (7) of the circuit is operated synchronously with the second switch (5) of the test circuit, wherein the first switch (4) of the test circuit (3) and the third switch (6) of the circuit (1) are operated countercyclically and synchronously to the second switch (5) of the test circuit (3) and the fourth switch (7) of the circuit (1).

9. The circuit according to any one of the claims 1 through 7, **characterized in that** the voltage source (30) is effectively switched into the traverse bridge branch (12) in a power buildup or discharge mode of operation, particularly **in that** the third switch (6) of the circuit is briefly not synchronously switched with the first switch (4) of the test circuit, and/or the fourth switch (7) of the circuit is not synchronously switched with the second switch (5) of the test circuit, but rather has a certain delay.

10. The circuit according to claim 9, **characterized in that** the power build-up or power dissipating operation is used in order to prevent an imminent magnetic saturation of the affected coils / transformers / leakage inductances when the controllable voltage source (13) is inductively coupled to the traverse bridge branch (12), particularly wherein the main inductance current of the coils / transformers / leakage inductances is preferably regulated to zero.

11. The circuit according to claim 9, **characterized in that** the power build-up or dissipating operation is used in order to charge or discharge the energy store with galvanic coupling of the controllable voltage source (13) to the traverse bridge branch (12), particularly wherein the controllable voltage source (13) is implemented as a four-quadrant-capable switchover circuit, wherein the internal voltage source is preferably designed as an energy store in the form of a capacitor or a battery.

## Revendications

1. Circuit de simulation d'une charge électrique sur une borne (2) d'un circuit de test (3), dans lequel le circuit de test (3) comporte au moins un premier interrupteur (4) et un deuxième interrupteur (5), dans lequel le circuit (1) comporte un troisième interrupteur (6) et un quatrième interrupteur (7), le premier interrupteur (4) et le deuxième interrupteur (5) du circuit de test (3) sont connectés à la borne (2) du circuit de test (3) via un premier point de connexion interne (8) commun, le troisième interrupteur (6) et le quatrième interrupteur (7) sont connectés entre eux via un deuxième point de connexion interne (9) commun, le premier interrupteur (4) et le troisième interrupteur (6) sont connectés entre eux via un premier point de connexion externe (10), et le deuxième interrupteur (5) et le quatrième interrupteur (7) sont connectés entre eux via un deuxième point de connexion externe (11), de telle sorte que le premier interrupteur (4), le deuxième interrupteur (5), le troisième interrupteur (6) et le quatrième interrupteur (7) forment un pont en H, le premier point de connexion externe (10) et le deuxième point de connexion externe (11) d'une source de tension (30) reçoivent une tension d'alimentation U_{B}, et le courant réel iᵢₛₜ passant par la borne (2) du circuit de test (3) passe par la branche transversale du pont (12) constituée entre la borne (2) et le deuxième point de connexion (9), dans laquelle est pourvue une inductance (14) qui agit dans la branche transversale du pont (12),
**caractérisé**
**en ce qu'**une source de tension contrôlable (13) est pourvue dans la branche transversale du pont (12) et le courant réel iᵢₛₜ peut être régulé conformément à la valeur d'un courant de consigne iₛₒₗₗ prédéterminé via une unité de régulation de courant (15) agissant sur la source de tension contrôlable (13).

2. Circuit selon la revendication 1, **caractérisé en ce que** la tension fournie par la source de tension contrôlable (13) est appliquée directement dans la branche transversale du pont (12) via un couplage galvanique.

3. Circuit selon la revendication 1, **caractérisé en ce que** la tension fournie par la source de tension contrôlable (13) est appliquée indirectement dans la branche transversale du pont (12) via un couplage inductif, en particulier via au moins un transformateur (16).

4. Circuit selon l'une des revendications 1 à 3, **caractérisé en ce que** la source de tension contrôlable (13) est réalisée à l'aide d'un dispositif de commutation à pont en H (17) avec une source de tension interne (18), en particulier un accumulateur d'énergie, et préférablement avec un condensateur.

5. Circuit selon la revendication 4, **caractérisé en ce que** le dispositif de commutation à pont en H (17) comporte un premier interrupteur (19), un deuxième interrupteur (20), un troisième interrupteur (21) et un quatrième interrupteur (22), le premier interrupteur (19) est connecté au deuxième interrupteur (20) via une première borne de pont (23), le deuxième interrupteur (20) est connecté au quatrième interrupteur (22), le quatrième interrupteur (22) est connecté au troisième interrupteur (21) via une deuxième borne de pont (24), et le troisième interrupteur (21) est connecté au premier interrupteur (19), dans lequel la source de tension interne (18) est connectée à la connexion commune (25) du premier interrupteur (19) et du troisième interrupteur (21) et est connecté à la connexion commune (26) du deuxième interrupteur (20) et du quatrième interrupteur (22), en particulier dans lequel la source de tension interne (18) est un condensateur.

6. Circuit selon l'une des revendications 1 à 5, **caractérisé en ce que** l'inductance (14) qui agit dans la branche transversale du pont (12) est réalisée sous forme d'une bobine et/ou sous forme d'une inductance de fuite ou d'une inductance de ligne parasitaire.

7. Circuit selon les revendications 6 et 3, **caractérisé en ce que** l'inductance (14) qui agit dans la branche transversale du pont (12) est présente sous forme d'une inductance de fuite du transformateur (16), en particulier grâce à une conception ciblée comme transformateur de fuite ou comme bobine à double enroulement.

8. Circuit selon l'une des revendications 1 à 7, **caractérisé en ce que**, en fonctionnement à puissance neutre, le circuit est agencé de telle sorte que le troisième interrupteur (6) du circuit est régulé de manière synchrone avec le premier interrupteur (4) du circuit de test, et le quatrième interrupteur (7) du circuit est régulé de manière synchrone avec le deuxième interrupteur (5) du circuit de test, dans lequel le premier interrupteur (4) du circuit de test (3) et le troisième interrupteur (6) du circuit (1) sont régulés de manière synchrone en opposition de phase avec le deuxième interrupteur (5) du circuit de test (3) et le quatrième interrupteur (7) du circuit (1).

9. Circuit selon l'une des revendications 1 à 7, **caractérisé en ce que**, en fonctionnement à puissance croissante ou décroissante, la source de tension (30) est connectée activement dans la branche transversale du pont (12), en particulier **en ce que** momentanément le troisième interrupteur (6) du circuit n'est pas connecté de manière synchrone avec le premier interrupteur (4) du circuit de test et/ou **en ce que** le quatrième interrupteur (7) du circuit n'est pas connecté de manière synchrone avec le deuxième interrupteur (5) du circuit de test, mais avec un certain délai.

10. Circuit selon la revendication 9, **caractérisé en ce que** le fonctionnement à puissance croissante ou décroissante est utilisé pour éviter une saturation magnétique imminente des bobines/transformateurs/inductances de fuite impliqués lors d'un couplage inductif de la source de tension contrôlable (13) avec la branche transversale du pont (12), en particulier dans lequel le courant d'inductance principal des bobines/transformateurs/inductances de fuite est préférablement régulé à une valeur nulle.

11. Circuit selon la revendication 9, **caractérisé en ce que** le fonctionnement à puissance croissante ou décroissante est utilisé pour charger ou décharger l'accumulateur d'énergie lors d'un couplage galvanique de la source de tension contrôlable (13) dans la branche du pont (12), en particulier dans lequel la source de tension contrôlable (13) est agencée sous forme d'un dispositif de commutation à pont en H, dans lequel la source de tension interne est préférablement conçue comme un accumulateur d'énergie sous forme d'un condensateur ou d'une batterie.
